# EUROPEAN PATENT APPLICATION

(11) **EP 3 904 112 A1**
(43) Date of publication of application: **03.11.2021**
(21) Application number: 20172068.7
(22) Date of filing: 29.04.2020
(51) Int. Cl.: B41M 5/26, G02B 21/34, G09F 3/00, G03F 7/20

(54) **PROCESS FOR THE INSCRIPTION OF GLASS MICROSCOPE SLIDES AND GLASS MICROSCOPE SLIDES OBTAINED THEREBY**

(71) Applicant: FA-TECH DIAGNOSTICS ITALIA S.R.L., 63074, San Benedetto del Tronto (AP) (IT)
(72) Inventor: Cucchi, Maurizio, 21038 Leggiuno Varese (IT)
(74) Representative: Serravalle, Marco

(57) **Abstract**

The invention is directed to a process for printing a microscope slide, wherein the process comprising subjecting a microscope slide comprising a coating to a printing step with a pulsated laser, and wherein the coating does not comprise an electromagnetic radiation-sensitive material.

The invention is also directed to a printed microscope slide with a monolayer of a coating which does not comprise an electromagnetic radiation-sensitive material, wherein the slide is leaser-printed with a black or grey character. Furthermore, the printed slide does not present any sign of ablation.

## Description

### Technical field of the invention

The present invention is directed to a process for printing microscope slides and to the microscope slide obtained by the method of the present invention. More particularly, the present invention is directed to a printing process comprising subjecting a microscope slide to a pulsating laser beam at a wavelength comprised between 350 and 750 nm.

Furthermore, the present invention is directed to the printed glass microscope slide wherein the writing by means of a pulsating laser does not result in ablation of the coating, but in a colour change of the coating which allows reading of the printed elements.

### Background of the invention

Microscope slides are a very commonly tools used in hospital and laboratories. It is an essential requirement to properly identify the sample which is used in connection with an individual slide. Such a task presents various difficulties since the glass must be very clear to facilitate viewing of test samples under the microscope. At the same time, glass is a surface which is very difficult to mark. Consequently, marking of the slides either with hand-written or with printed information requires a modification of the glass surface below the viewing area to make it suitable for writing/printing.

Laser marking is becoming increasingly popular. The advantages of laser marking over conventional printing processes is that the laser mark is permanent and solvent resistant. However, laser marking of slides presents peculiar problems. Because of the large use of microscope slides, it is important to use a laser source which is not too expensive, but this fact reduces the choice of the laser. Furthermore, while printing requires a certain amount of energy, microscope slides are thin and present on the surface a very thin coating. Consequently, the use of a high energy easily results in puncturing of the slide.

US 5,683,786 discloses a microscope slide having a laser-inscripted bar code, wherein the inscription is obtained by ablating a coating by the use of a laser beam. The disadvantage of this method is that the inscription is only visible if the surface below the slide has a different colour than the coating, being the ablated surface transparent.

EP 2 226 123 tries to overcome this problem by coating the microscope slide with a substance which is sensitive to electromagnetic radiation. In this way, the laser beam produces a colour change in the light-sensitive coating. However, the use of this sensitive coating increases the cost of the slide.

US 9,637,651 discloses the use of bismuth oxide with oxygen deficiencies as an additive in coatings to improve laser marking.

It is therefore desirable to reduce the cost of a slide while maintaining a good readability of the markable region after laser-print.

### Summary of the invention

The present invention is directed to a process for printing glass microscope slides coated with a coating which does not comprise any colour pigment, which process comprises printing the slide with a pulsating laser at a wavelength comprised 350 and 750 nm.

The invention is also directed to a glass microscope slide comprising a printing area coated with polymeric material which does not contain any pigment, which slide is laser-printed. The printed area presents a black/grey mark which is clearly readable by a naked-eye or by a machine.

### Brief description of the figures

Fig. 1 is a picture of various specimen laser-printed by a diode pumped solid state laser at 532 nm (green).
Fig. 2 is a picture of the identical specimen laser printed by a diode pumped solid state laser at 1064 nm (IR).

### Detailed description of the invention

A microscope slide typically comprises a transparent plate made of glass or transparent plastic. Typical dimensions of microscope slides are 75 mm x 25 mm x 1.1 mm. The upper face of the slide usually comprises a markable area, having a surface area of 25 mm x 20 mm. The markable area usually comprises a coating.

A coating suitable for microscope slides can be obtained in several ways, e.g. by crosslinking or polymerization of a carrier or by loss of a solvent. Carriers useful in the preparation of coatings comprise but are not limited to polyurethane, polyester resins, polyamides, epoxy resins. Most common carriers are selected from a polyamide or an epoxy resin. The coatings used for microscope slides are characterized by a good scratch resistance, resistance to solvents and printability with common printers (ink-jet, and other conventional printers). Up to date, common IAG laser printers are only used in combination with doped slides.

The inventors have surprisingly found that by printing a microscope slide with a pulsating laser, e.g. a diode pumped solid state green laser (532 nm), it is possible to mark the slide in a clear manner, even when the slide coating does not comprise an electromagnetic radiation-sensitive pigment. In fact, the use of a pulsating laser beam produces a black/grey mark on various coatings commonly used in glass microscope slides. Consequently, the invention provides a laser-printed slide wherein the coated area of the slide does not contain any electromagnetic radiation-sensitive substance.

Electromagnetic radiation-sensitive substances are disclosed in EP 2 226 671 and US 5,840,791, US 9,637,651 and EP 400 305 all herein incorporated by reference. Examples of such substances are copper mixed metal oxide pigments, more specifically copper molybdenum tetraoxide; boric anhydride, optionally in combination with copper pyrophosphate or hydrate or antimonium trioxide; copper (II) hydroxide phosphate; bismuth oxide with oxygen deficiencies; molybdenum (VI) oxide.

The printed slide of the present invention presents a colour change of the coating due to blackening of the coating polymer. This blackening is caused by the interaction between the laser beam and the polymer. The coating, after printing, is still uniformly distributed on the slide, i.e. the slide does not undergo ablation when laser printed. Ablation is a side effect which might easily occur and is the most common effect of laser printing in the field of microscope slides. This effect is also favoured by the low thickness of the coating, which is usually comprised between 5 and 50 microns, preferably from 20 to 30 microns, usually about 25 microns.

The pulsating laser useful for marking microscope slides can be any laser that is capable of producing a beam at a wavelength comprised between 350 and 750 nm with a peak power of at least 5 kW. In fact, it has been found that laser beams operating at a longer wavelength (e.g. 1064 nm) produce heating of the coating and eventually ablation. The use of a shorter wavelength allows the energy of the laser beam to result in a chemical modification of the coating, which produces the change in colour, normally from white to gray/black (blackening of the coating).

The type of laser is not particularly limited as long as the laser is capable of providing a beam with the desired characteristics, e.g. pulse frequency, repetition energy, pulse width, average power, peak power, wavelength, etc. Examples of suitable lasers are diode pumped solid state (DPSS) lasers and pulsed Yb doped fiber lasers. Amongst the various DPSS lasers suitable for the present invention, we can mention Nd doped YVO₄ and Nd doped YAG. The most preferred is a Nd doped YAG since it is the less expensive.

In order to mark a slide, it is important to operate with a peak power of at least 5kW. Preferably the laser beam produces a peak power comprised between 5 and 40 kW, more preferably between 8 and 35 kW, even more preferably between 9 and 24 kW, most preferably between 12 and 20 kW.

Since peak power is obtained by dividing the pulse energy by the duration of the pulse, 10 kW peak power can be obtained for example by a pulse of 10 µJ for a time pulse of 1 ns or by a pulse of 100 µJ for a time pulse of 10 ns. Preferably, the above defined peak power is obtained by a pulse width comprised between 0.10 ns and 5.0 ns, more preferably between 0.50 ns and 3.0 ns.

The repetition frequency can vary in a broad range but is preferably comprised between 10 kHz to 50 kHz. The average power of the pulsed laser used in the present invention is comprised between 0.1 and 5.0 W. In case of pulsed YAG laser, they usually have an average power lower than or equal to 1 W and a frequency pulse equal to 35 kHz.

Concerning the wavelength of the laser beam, it has been found that an IR laser beam (1064 nm) does not result in a clear marking of the slides, while laser beam with a shorter wavelength (355-750 nm) are effective. Without being bound to a theory, it is believed that the energy of the laser with a shorter wavelength is more apt to be transformed at a molecular level, i.e. chemical reactions which produce the blackening of the coating) rather than into thermal energy, which produces heating of the coating and eventually ablation.

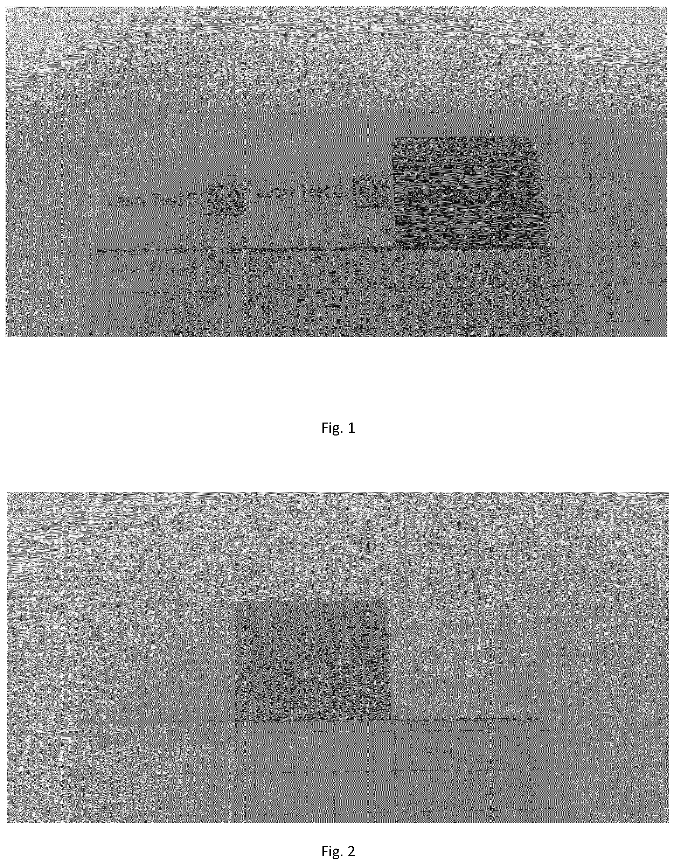

Figure 1 clearly shows that different microscope slides from different producers, which do not comprise any electromagnetic radiation-sensitive compound, can be clearly marked by the process of the present invention making use of a green pulsed laser. The same slides are very lightly marked by an infrared pulsed laser as illustrated in figure 2.

The mark obtained by using a green pulsed laser does not ablate the coating but produces a colour change in the coating due to the interaction between laser beam and coating. The present invention for the first time discloses a printed microscope slides which is printed by using a pulsed laser in the absence of doping agent and without ablating the coating.

The process of the present invention combines the advantages of using an YAG laser, i.e. low cost of the laser, with the advantages of using a non-doped slide. The cost of a diode pumped solid state green laser is somehow higher than the cost of a diode IR laser. However, this extra cost is rapidly recovered by the saving in the cost of the non-doped slides.

The process of the present invention is also flexible in that several different slides from different producers have been tested and the result has been always positive. Thus, the user does not need to pay particular attention to the type of coating of a slide since the green laser is capable of marking commercially available slides.

### Experimental part.

Microscope slides from the following producers were subjected to green laser printing: Thermo Fisher Scientific, Menzel, Knittle, Meinfeld, Leica, Sakura, Matsunami, Muto Chemicals, WVR-Klinipath, Cytotest, Porlab. The slides were printed by two different lasers:
. The first laser used for printing the slides was the following: printing conditions were the following:
Nd:YVO4 , DPSS
Wavelength 532 nm
Average power max 0,5 W
Pulse frequency from 10 to 200 kHz
Pulse width 800 ps.
Peak power 22 kW
A second laser had the following characteristics:
Nd:YAG , DPSS
Wavelength 532 nm
Average power max 1 W
Pulse frequency 35 kHz
Pulse width 2,5 ns
Peak power 13 kW
The results are shown in figure 1

By comparison, the identical slides have been printed with an IR Nd:YAG laser having the same characteristics of laser 2. The comparative results of the printing work are shown in figure 2.

## Claims

1. A process for printing a microscope slide, wherein the process comprising subjecting a microscope slide comprising a coating to a printing step with a pulsed laser emitting a beam at a wavelength comprised between 350 and 750 nm, and wherein the coating does not comprise an electromagnetic radiation-sensitive material.

2. The process according to claim 1, wherein the printing step is performed at a peak power comprised between 5 kW and 40 kW.

3. The process according to claims 1-2, wherein the laser is a diode pumped solid state (DPSS) laser or a doped pumped fiber laser.

4. The process of claim 3, wherein the DPSS laser is a Nd doped YAG laser.

5. The process of claims 1-4, wherein the laser operates at a wavelength of 532 nm.

6. The process of claims 2-5, wherein the peak power is comprised between 8 kW and 35 kW, preferably between 9 kW and 24 kW.

7. The process according to claims 1-6, wherein the laser has a pulse width comprised between 0.50 and 5 ns, preferably between 0.50 and 3 ns.

8. The process according to claims 1, wherein the slides are coated with an epoxy resin or a polyamide.

9. The process according to claims 1-8, wherein the electromagnetic radiation-sensitive material is selected from copper molybdenum tetraoxide; boric anhydride, optionally in combination with copper pyrophosphate or hydrate or antimonium trioxide; copper (II) hydroxide phosphate; bismuth oxide with oxygen deficiencies; molybdenum (VI) oxide.

10. A microscope slide with a monolayer of a coating which does not comprise an electromagnetic radiation-sensitive material, wherein the slide is leaser-printed with a black or grey character.

11. The slide of claim 10, wherein the coating is a polyamide or an epoxy resin.

12. The slide of claims 10-11, wherein the colour change in the coating is due to blackening of the polymer of the coating.

13. The slide of claims 10-12, wherein the coating after printing is uniformly present on the slide.

14. The slide of claims 5-6, wherein the thickness of the coating is comprised between 5 and 50 microns.
